# EUROPEAN PATENT APPLICATION

(11) **EP 3 896 678 A1**
(43) Date of publication of application: **20.10.2021**
(21) Application number: 19896920.6
(22) Date of filing: 22.11.2019
(51) Int. Cl.: G09F 9/00, G02F 1/13, G02F 1/1334, G02F 1/15, G02F 1/19, G06F 3/01, G06F 3/0488, G09G 5/00, G09G 5/38, H01L 27/32, H01L 51/50, H05B 33/02, H05B 33/14

(54) **TRANSPARENT GLASS PROVIDED WITH TRANSPARENT DISPLAY**

(30) Priority: 11.12.2018 JP 2018231268
(71) Applicant: AGC INC., Chiyoda-ku, Tokyo 1008405 (JP)
(72) Inventor: FUKUI, Takashi, Tokyo 100-8405 (JP); OTA, Kaoru, Tokyo 100-8405 (JP); OKUBO, Hirotsune, Tokyo 100-8405 (JP); SUENAGA, Kotaro, Tokyo 100-8405 (JP)
(74) Representative: Müller-Boré & Partner Patentanwälte PartG mbB
(86) International application number: PCT/JP2019/045749
(87) International publication number: WO 2020/121779

(57) **Abstract**

There is provided clear glass (20) including a transparent display (22) in which picture elements emit light by themselves. The clear glass (20) further includes a light control sheet (23) that covers a back of the transparent display (22). While a picture is displayed on the transparent display (22), light and darkness of the light control sheet (23) is capable of being controlled in accordance with a magnitude of voltage applied to the light control sheet (23). The light and darkness of the light control sheet (23) is controlled such that the light control sheet (23) is made to be bright by increasing a transmittance of the light control sheet (23) and is made to be dark by decreasing the transmittance of the light control sheet (23).

## Description

### Technical Field

The present invention relates to clear glass, particularly to clear glass including a transparent display in which picture elements emit light by themselves.

### Background Art

Patent Literature 1 discloses a transparent partition wall in which liquid crystal displays are arranged in an up-down direction and a right-left direction (paragraph [0106]). The liquid crystal displays can be replaced with organic electroluminescent displays or inorganic electroluminescent displays (paragraph [0118]).

### Citation List

### Patent Literature

Patent Literature 1: Japanese Unexamined Patent Application Publication No. 2007-061446

### Non Patent Literature

Non Patent Document 1: Kenta Kasuya, Hiroshi Sakamoto, Hitoshi Tsushima, Shinichi Uehara, Yukio Endo and Takashi Fukui, "Visibility Evaluation of Direct-Bonded Signage Display for Outdoor Use", The Society for Information Display Technical Digests consist of short papers and poster session content from SID's annual symposium, Display Week., First Published 30 May 2018, 25-4, p.324-327

### Summary of Invention

### Technical Problem

In a liquid crystal display, picture elements do not emit light by themselves. To make a partition wall including a liquid crystal display transparent, it is necessary to place a backlight separately inside the partition wall. In an aspect, light from the backlight is caused to diffuse into a space inside the partition wall. In an aspect, a transparent light guide panel and a diffuser panel of a side edge type are provided in the partition wall. In these aspects, it is difficult to cause the light from the backlight to reach the center of the partition wall. When light is incident from the front or the back of the partition wall, it is difficult to make a picture that appears on a transparent liquid crystal display have vivid colors. In the case of a picture having vivid colors, the transparency of the partition wall is impaired.

In an organic electroluminescent display or an inorganic electroluminescent display, picture elements emit light by themselves. In a transparent display in which picture elements emit light by themselves, when bright light is incident from the back side of the display, picture elements in a black state are made to be bright. This decreases the contrast of a picture displayed on the transparent display. The same problem arises in a clear glass including a transparent display in which picture elements emit light by themselves. An objective of the present invention is to provide, for a clear glass including a transparent display in which picture elements emit light by themselves, a method for restraining the contrast of a picture displayed on the transparent display from being decreased.

### Solution to Problem

<1> Clear glass including a transparent display in which picture elements emit light by themselves, the clear class further including
   a light control sheet covering a back of the transparent display, wherein
   while a picture is displayed on the transparent display, light and darkness of the light control sheet is capable of being controlled in accordance with a magnitude of voltage applied to the light control sheet, and
   the light and darkness of the light control sheet is controlled such that the light control sheet is made to be bright by increasing a transmittance of the light control sheet and is made to be dark by decreasing the transmittance of the light control sheet.
<2> The clear glass according to <1>, including
   display layer glass and light control layer glass that face each other,
   the transparent display is attached to the display layer glass, and
   the light control sheet is attached to the light control layer glass.
<3> The clear glass according to <2>, wherein
   a space is provided between the display layer glass and the light control layer glass, and
   the transparent display and the light control sheet are provided on the space side of the display layer glass and the light control layer glass, respectively.
<4> The clear glass according to <3>, wherein
   the clear glass is a multi-layered glass including the display layer glass and the light control layer glass, and
   the space is enclosed.
<5> The clear glass according to <3>, further including a touch panel that is provided on a surface of the display layer glass, the surface being on an opposite side of the display layer glass from the transparent display.
<6> The clear glass according to <1>, wherein a part of the light control sheet is divided into regions, the part facing the transparent display, and light and darkness of each of the regions is capable of being controlled.
<7> The clear glass according to <1>, wherein the light control sheet is of any one of a suspended particle device (SPD) type, a polymer dispersed liquid crystal (PDLC) type, a guest host liquid crystal (GHLC) type, and an electrochromic type.
<8> The clear glass according to <7>, wherein
   the light control sheet is made to be bright while voltage is applied to the light control sheet, whereas the light control sheet is made to be dark while no voltage is applied to the light control sheet, or
   the light control sheet is made to be dark while voltage is applied to the light control sheet, whereas the light control sheet is made to be bright while no voltage is applied to the light control sheet.
<9> A controller that is to be connected to the clear glass according to any one of <1> to <8>, wherein while inputting a picture signal to the transparent display, the picture signal being received from an outside, the controller controls light and darkness of the light control sheet by changing voltage applied to the light control sheet based on a control signal received from the outside.
<10> The controller according to <9>, wherein
   as a picture on the transparent display is made to be bright, a back of the transparent display is made to be dark with the light control sheet, and
   as the picture on the transparent display is made to be dark, the back of the transparent display is made to be bright with the light control sheet.
<11> A transparent display apparatus including:
   the clear glass according to any one of <1> to <8>; and
   a controller that is to be connected to the clear glass, the controller
   wherein while inputting a picture signal to the transparent display, the controller controls light and darkness of the light control sheet by changing voltage applied to the light control sheet.
<12> The transparent display apparatus according to <11>, further including an illuminance sensor that measures illuminance of a back of the light control sheet, wherein
   the illuminance is acquired from the illuminance sensor continuously or periodically, and
   the controller makes the light control sheet dark when the illuminance is increased, and the controller makes the light control sheet bright when the illuminance is decreased.
<13> The transparent display apparatus according to <11>, wherein
   a part of the light control sheet is divided into regions, the part facing the transparent display, and the controller is connected to each of the regions of the light control sheet,
   the picture signal includes a gradation expression and a solid figure pattern expression that are to be displayed simultaneously with each other, and
   the controller makes one of the regions of the light control sheet, the one of the regions being behind a picture of the gradation expression in the transparent display, darker than one of the regions of the light control sheet, the one of the regions being behind a picture of the solid figure pattern expression in the transparent display.
<14> The transparent display apparatus according to <13>, wherein
   the solid figure pattern expression includes a two-dimensional code, and the controller exceptionally makes one of the regions that is behind a picture of the two-dimensional code in the transparent display dark.
<15> A method for using the clear glass according to <5> in a transportation, the method including:
   (A)
      transmitting a request as basic information from the transportation to a server over a network, the request being input by a passenger or a crew member with the touch panel;
   (B)
      analyzing the basic information received by the server, further generating service information to be provided to a passenger or a crew member based on a result of the analysis, and further transmitting the service information from the server over the network; and
   (C)
      displaying the service information received by the transportation on the transparent display in a form of a picture, further, determining light and darkness of a back of the picture based on the service information and controlling the light, and light and darkness of the back of the picture with the light control sheet.
<16> A method for using the clear glass according to any one of <1> to <4>, <7>, and <8> in a transportation, the method including:
   (A)
      transmitting, from the transportation to a server over a network, at least any one of pieces of basic information:
      a position of the transportation that is acquired by reception of a GPS signal or capturing an image of an exterior of the transportation; and
      information on an interior of the transportation that is obtained by capturing an image of the interior of the transportation, the information including or not including information on a passenger or a crew member;
   (B)
      analyzing the basic information received by the server, further generating service information to be provided to a passenger or a crew member based on a result of the analysis, and further transmitting the service information from the server over the network; and
   (C) displaying the service information received by the transportation on the transparent display in a form of a picture, further, determining light and darkness of a back of the picture based on the service information and controlling the light, and light and darkness of the back of the picture with the light control sheet.
<17> A method for using the clear glass according to any one of <1> to <4>, <7>, and <8> in a transportation, the method including:
   placing the clear glass in advance such that a front face of transparent display faces a position of a passenger or a crew member in the transportation;
   acquiring a direction of a line of sight of the passenger or the crew member with a monitoring camera provided in the transportation; and
   determining, based on the direction of the line of sight of the passenger or the crew member, a display position of information in the transparent display, the information being to be displayed on the transparent display.

### Advantageous Effects of Invention

It is possible to restrain, in a clear glass including a transparent display in which picture elements emit light by themselves, the contrast of a picture displayed on the transparent display from being decreased.

### Brief Description of the Drawings

[Fig. 1] Fig. 1 is a perspective view of clear glass.
[Fig. 2] Fig. 2 includes a front view 1 and a cross-sectional view of the clear glass.
[Fig. 3] Fig. 3 is a front view 2 of the clear glass.
[Fig. 4] Fig. 4 is a front view 3 of the clear glass.
[Fig. 5] Fig. 5 is an in-use view 1 of the clear glass.
[Fig. 6] Fig. 6 is a perspective view of a transparent display and a light control sheet.
[Fig. 7] Fig. 7 is an in-use view 1 of the light control sheet.
[Fig. 8] Fig. 8 is a front view of the transparent display.
[Fig. 9] Fig. 9 is an in-use view 1 of the combination of the transparent display and the light control sheet.
[Fig. 10] Fig. 10 is an in-use view 2 of the combination of the transparent display and the light control sheet.
[Fig. 11] Fig. 11 is an in-use view 2 of the clear glass.
[Fig. 12] Fig. 12 is an in-use view 3 of the combination of the transparent display and the light control sheet.
[Fig. 13] Fig. 13 is an in-use view 2 of the light control sheet.

### Description of Embodiments

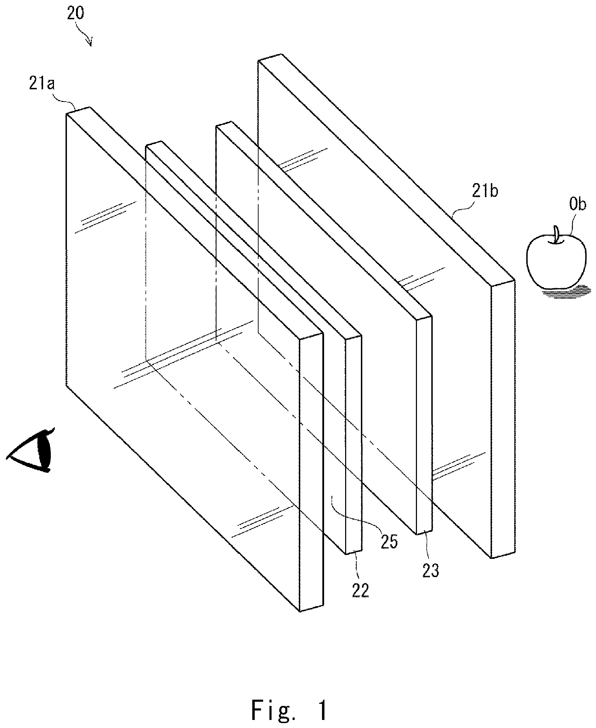

Fig. 1 is a perspective view of clear glass 20. The clear glass 20 is a glass plate that allows a picture to be displayed toward the front side of the clear glass 20. According to the drawing, the clear glass 20 is capable of bringing about a state where an object Ob present on the back side of the clear glass 20, namely, the right-rear side of the drawing, is seen through from the front side of the clear glass 20, namely, the front-left side of the drawing. For convenience, the front-left side of the drawing is considered to be the front of the clear glass 20, and the right-rear side of the drawing is considered to be the back or the rear of the or clear glass 20. The clear glass 20 includes a main plate 21a. In an aspect, the main plate 21a is transparent plate glass. Surfaces of the main plate 21a are smooth on both the front side and the back side.

The main plate 21a is herein an optical element. The optical element herein refers to a component of the clear glass 20 and any possible component that influence a transmittance of the clear glass 20. The optical element herein refers to an optical element onto which external light is incident from the rear thereof, inside which the incident light passes, and from the front of which the passing light exits. The optical element may be an optical device. In the present embodiment, a visible light transmittance of the optical element is taken into consideration. The main plate 21a transmits visible light at a predetermined transmittance.

In Fig. 1, the main plate 21a may be tempered glass. Tempered glass has a higher strength than float glass. An aspect of the tempered glass is glass on surfaces of which compressive stress layers are formed. An aspect of the tempered glass is a glass of which surfaces are strengthened through an ion exchange strengthening method.

In Fig. 1, the main plate 21a may be laminated glass. Laminated glass refers to glass that is obtained by bonding two or more panels of glass together. The main plate 21a may be laminated glass made of tempered glass.

In Fig. 1, the main plate 21a may be produced by stacking a material other than glass on a glass substrate. The material other than glass may be resin. Note that materials of the main plate 21a exclude materials other than glass with vitreous coating.

As illustrated in Fig. 1, the clear glass 20 further includes a transparent display 22. In an aspect, the transparent display 22 is present behind the main plate 21a. The transparent display 22 includes a screen 25. The transparent display 22 displays a picture from the screen 25 toward the front-left side of the drawing. The transparent display 22 is a display capable of bringing about a state where an object Ob present on the back side of the screen 25, namely, the right-rear side of the drawing, is seen through from the front side of the screen 25, namely, the front-left side of the drawing. The transparent display 22 is herein an optical element. The transparent display 22 emits light by itself and transmits visible light incident thereto from the outside at a predetermined transmittance.

In Fig. 1, the transparent display 22 includes picture elements that emit light by themselves. In the present embodiment, the phase "emitting light by itself" means that a picture element receives electric energy from the outside of the picture element, converts the electric energy into light energy inside the picture element, and releases the light energy to the outside of the picture element. Hereinafter, a display including picture elements emitting light by themselves may be referred to as a self-light-emitting (transparent) display. The term "self-light-emitting" means that showing color is not dependent on a backlight or external light. The self-light-emitting (transparent) display is capable of displaying an image even in the darkness.

The transparent display 22 may a full-color display or a single-color display. The transparent display 22 is preferably capable of performing gradation expression. The transparent display 22 is preferably capable of expressing a solid figure pattern. The transparent display 22 is preferably capable of making a background of a solid figure pattern black. For the self-light-emitting transparent display, being black means that picture elements do not emit light. That is, black looks transparent.

In Fig. 1, the transparent display 22 may be a transparent organic light-emitting (EL) display. The transparent organic electroluminescent display may be a display including active-matrix organic light-emitting elements. The active-matrix organic light-emitting element is also called active matrics organic light emitting diode (AMOLED). In the AMOLED, an active element such as a thin film transistor (TFT) is disposed in each picture element and driven. An organic light emitting diode (OLED), which includes the AMOLED, is an injection EL element, of which excitation is caused by injection of electrons/positive holes.

In Fig. 1, as a contrivance to increase a transparency of the transparent organic electroluminescent display used for the transparent display 22, it is first necessary to use a transparent substrate for the EL elements. The substrate may be a glass substrate and a resin substrate. The resin substrate may be one made of a resin film. The substrate for the EL elements is distinguished from the main plate 21a. To further increase the transparency, a driver circuit for TFT drive may be disposed outside the clear glass 20 with a printed film disposed on the periphery of the transparent display 22 or the substrate interposed therebetween. For concealing the printed film or the substrate, printing may be performed on the main plate 21a. The printing may be performed on both or any one of the front side and the back side of the main plate 21a. Another conceivable contrivance to increase the transparency is attaching the transparent display 22 to the main plate 21a using bonding material that is transparent at least after bonding. In this case, it is preferable that the entire surface of the screen 25 be attached to the main plate 21a. The bonding material may be mainly made of resin or may be made of only resin. A difference in refractive index between the bonding material after bonding and the main plate 21a is preferably within ±8% with respect to the refractive index of the main plate 21a. Such bonding material is called optical adhesive or optical plastic.

In Fig. 1, the transparent display 22 may be a transparent inorganic electroluminescent display. The transparent inorganic electroluminescent display may be a display including intrinsic EL elements, of which excitation is caused by an electric field. Examples of an available transparent inorganic electroluminescent display include, but not limited to, a display with the trade name: TASEL (produced by Beneq).

As the transparent display 22 illustrated in Fig. 1, for example, macroscale displays in which picture elements having a several-millimeter-square size are arranged every 2 to 10 cm are excluded. In such a display, external light freely passes through gaps between picture elements. Even when picture elements are opaque, the display looks substantially transparent when the display is seen from so far away that the size of the picture elements cannot be visually checked. Such a display is suitable for, for example, outdoor signage that is installed on a window of a building. In contrast, the clear glass 20 according to the present embodiment is to provide a more detailed display for a person who comes close to the clear glass 20. Picture elements of the transparent display 22 are densely arranged every 2 cm or less.

The transmittance of the transparent display 22 illustrated in Fig. 1 may be measured based on JIS R 3106:1998. The transmittance of the transparent display 22 illustrated in Fig. 1 may be measured based on ISO 8478:1996. As used herein, the transmittances of the transparent display 22 and the other optical elements indicate visible light transmittances unless otherwise stated. Ultraviolet light transmittances and infrared light transmittances of the transparent display 22 and the other optical elements can be herein specified to any transmittances.

As illustrated in Fig. 1, the clear glass 20 further includes a light control sheet 23. When the light control sheet 23 is bright, the transparent display 22 preferably has a transmittance of 10 to 80%. When the light control sheet 23 is dark, the transparent display 22 preferably has a transmittance of 30 to 80%.

The light control sheet 23 covers a back of the transparent display 22. The light control sheet 23 may have the same size as the transparent display 22 or may have a size larger than that of the transparent display 22. A gap between the transparent display 22 and the light control sheet 23 is preferably 30 mm or less.

In Fig. 1, the light control sheet 23 is what is called a light shutter. In an aspect, light and darkness of the light control sheet 23 can be controlled in accordance with the magnitude of voltage applied to the light control sheet 23. The applied voltage may be of alternating current or direct current. The control of the light and darkness of the light control sheet 23 can be performed while a picture is displayed on the transparent display 22.

In Fig. 1, the light control sheet 23 is not a mere light shielding plate. In other words, the function to be required for the light control sheet 23 is not satisfied by control of transmittance of the light control sheet 23 before the light control sheet 23 is incorporated into the clear glass 20 and fixation of transmittance thereof after being incorporated into the clear glass.

In Fig. 1, the light control sheet 23 becomes brighter as the transmittance of the light control sheet 23 increases. Further, the light control sheet 23 becomes darker as the transmittance of the light control sheet 23 decreases. The light control sheet 23 does not necessarily have to decrease the transmittance due to the increase in scattering. The light control sheet 23 may also block even scattered light to be transmitted. In addition, a subsidiary function of the light control sheet 23 of generating scattered light from light to be transmitted therethrough, is not excluded from the technical scope of the light control sheet 23. On the other hand, the change in transmittance due to the light control sheet 23 may be caused by a diffusion phenomenon of light in the light control sheet 23. An example of such a material includes a dye-doped G-H (guest-host-) material. The dye to be doped is a dichroic dye. The dichroic dye is a guest. A substance doped with the dichroic dye is a liquid crystal. The liquid crystal is a host. The dichroic dye is oriented along the orientation of liquid crystal molecules. The dichroic dye absorbs light of a specific wavelength in this state. Therefore, the dichroic dye gives coloring to the light control sheet 23 with a specific color. When the orientation of the liquid crystal molecules changes due to the application of voltage, the orientation of the dichroic dye also changes along with liquid crystal molecules. The dichroic dye absorbs light having a wavelength different from that of the specific wavelength described above in this state. Accordingly, the dichroic dye gives coloring to the light control sheet 23 with a color different from the specific color described above. The material varies between a clear glass-like state with a small haze and a frosted glass-like state with a large haze. The light control sheet 23 made of such a material does not block the scattered light to be transmitted. The light control sheet 23 made of such a material decreases in transmittance due to only an increase in scattering. The light control sheet 23 made of such a material only scatters the transmitted light that reaches the transparent display 22 from the back side of the light control sheet 23, and may not block the transmitted light at all. The light control sheet 23 made of such a material becomes brighter due to the increase in transmittance. The light control sheet 23 made of such a material remains bright even when the light control sheet 23 decreases in transmittance. The type of the light control sheet 23 made of the dye-doped G-H (guest-host) material is not particularly limited.

In Fig. 1, the maximum value of the amount of change in transmittance of the light control sheet 23 is preferably a value of 20 to 60 points. The amount of change may be any of 30, 40, and 50 points. Here, 1 point indicates that the difference in transmittance is 1%. It is preferable that the light control sheet 23 can freely change brightness and darkness in this section. In one example, the transmittance of the light control sheet 23 varies from 30% to 70%. Under control, the transmittance of the light control sheet 23 may continue to be maintained at an intermediate value between brightness and darkness. When the light control sheet 23 is bright, the transmittance of the light control sheet 23 is preferably 40% or more. The transmittance of the light control sheet 23 may be measured based on JIS R 3106: 1998. The transmittance of the light control sheet 23 may be measured based on ISO 8478: 1996. Herein, the light control sheet 23 is an optical element. The light control sheet 23 has a transmittance that changes depending on the control, and allows visible light to transmit. The light control sheet 23 may not substantially allow the visible light to transmit.

In Fig. 1, the light control sheet 23 may be opaque in one aspect in a state of not receiving a voltage. To quote the term of liquid crystal technology, the light control sheet 23 may be "normally-black". In other words, when a voltage is applied to the light control sheet 23, the light control sheet 23 becomes bright, but when no voltage is applied to the light control sheet 23, the light control sheet 23 becomes dark. Such a light control sheet 23 may be either an SPD (Suspended Particle Device)-type light control sheet or a PDLC (Polymer Dispersed Liquid Crystal)-type light control sheet. In one example, the brightness and darkness of the SPD-type light control sheet are switched in a few seconds. The light control sheet 23 may be configured such that the light control sheet 23 becomes transparent when a voltage is applied to the light control sheet 23, and the light control sheet 23 becomes frosted glass when no voltage is applied to the light control sheet 23. Such a light control sheet may be a GHLC (Guest Host Liquid Crystal)-type light control sheet. The GHLC (Guest Host Liquid Crystal)-type light control sheet may be made of the dye-doped G-H (guest-host) material. In one example, the brightness and darkness of the GHLC-type light control sheet are switched in about 0.1 seconds brightness and darkness. The light control sheet 23 may be a bistable-type light control sheet or a memory-type light control sheet. An example of the bistable-type light control sheet or the memory-type light control sheet is an electrochromic-type light control sheet. When a voltage is applied to the electrochromic-type light control sheet 23 in a dark state, the light control sheet 23 changes to a transparent state. When a state in which the bistable-type or memory-type light control sheet 23 is not subjected to a voltage change equal to or higher than a threshold value is continued, the light control sheet 23 is maintained to be transparent. When a voltage is applied to the light control sheet 23 while the bistable-type or memory-type light control sheet 23 is in a transparent state, the light control sheet 23 changes to a further opaque state. When the state in which the bistable-type or memory-type light control sheet 23 is not subjected to the voltage change equal to or higher than a threshold value is continued, the light control sheet 23 is maintained in a further opaque state. In one example, brightness and darkness of the electrochromic-type light control sheet are switched in about 20 to 180 seconds.

At this time, as the light control sheet 23, a plurality of the same type or different types of light control sheets may be used. When the plurality of light control sheets are used, an intermediate state between the bright state and the dark state can be realized. A portion being in the intermediate state is not enough dark or enough bright. The switching between brightness and darkness occurs in a shorter time by using of the intermediate state.

Further, a sensor may be added to the light control sheet 23. The brightness and darkness states may be automatically switched according to surrounding environments by using the sensor. A threshold voltage of the light control sheet may be controlled by the sensor. By a combination of the light control sheet having the threshold voltage to be controlled with any light control sheet selected from the GHLC-type, the PDLC-type, the SPD-type, and the electrochromic-type light control sheets, it is possible to switch the intermediate state of the brightness and darkness, a state of being sufficiently growing darker, and a state of being sufficiently growing brighter. The switching of the brightness and darkness can be performed in a shorter time by using of the intermediate state as compared with a case where a sensor is not used.

In Fig. 1, the light control sheet 23 may be transparent in one aspect in a state of not receiving a voltage. To quote the term of liquid crystal technology, the light control sheet 23 may be "normally-white". When a voltage is applied to the light control sheet 23, the light control sheet 23 becomes dark, but when no voltage is applied to the light control sheet 23, the light control sheet 23 becomes bright. A general liquid crystal shutter may be used as the light control sheet 23. The general liquid crystal shutter can exchange normally-black and normally-white depending on a direction of a polarizing plate provided in the liquid crystal shutter. As another liquid crystal shutter, for example, the Transmart manufactured by AGC may be used. The Transmart varies between a clear glass-like state with a small haze and a frosted glass-like state with a large haze. The Transmart is transparent when no voltage is applied.

In Fig. 1, the brightness and darkness of the light control sheet 23 may be controlled by a controller (not shown). The controller further applies a voltage to the light control sheet 23 while inputting a picture signal to the transparent display 22. The controller controls the brightness and darkness of the light control sheet 23 by changing the voltage. A transparent display apparatus can be provided by a combination of the controller with the clear glass 20. The transparent display device may be further added with various communication units, sensors, and programmable microcomputers.

As shown in Fig. 1, the clear glass 20 may further include a sub plate 21b. In one aspect, the sub plate 21b is provided behind the light control sheet 23. In one aspect, the sub plate 21b is transparent plate glass. A surface on a front side and a surface on a back side of the sub plate 21b are smooth. In one example, a set of the main plate 21a and sub plate 21b has transmittance of 85 to 95%. In one example, the transmittance of the main plate 21a is equal to the transmittance of the sub plate 21b. The transmittance of the main plate 21a, the transmittance of the sub plate 21b, and the transmittance of the set thereof may be measured based on ISO 9050: 2003 or JIS R 3106: 1998. Herein, the sub plate 21b is an optical element. The sub plate 21b has a predetermined transmittance and allows the visible light to transmit.

One aspect of the sub plate 21b shown in Fig. 1 is privacy glass. The privacy glass has preferably a visible light transmittance of 30 to 70%. By using such a privacy glass-type sub plate 21b, it is possible to increase a contrast of a picture while maintaining the transmittance of the clear glass 20 within a predetermined range. The privacy glass preferably contains a coloring material, and specifically, the glass preferably contains any one of Fe, Ti, Ce, Co, Se, Cr, Cu, and Ni as a coloring material.

In another aspect, the sub plate 21b itself has the same function as the light control sheet 23. In another aspect, the sub plate 21b and the light control sheet 23 are integrated. In one aspect, the sub plate 21b is light control function-equipped glass. In one aspect, the light control function-equipped glass is glass in which its own transmission is changed by discoloring of the glass itself to ensure privacy. When the outside of the sub plate 21b is bright, the sub plate 21b discolors and acts as a blind or a curtain. When the outside of the sub plate 21b is dark, the sub plate 21b secures an observer's field of view by an increase in its own transmission. In one aspect, the sub plate 21b absorbs sunlight that illuminates itself and actively warms the room with its energy.

In one aspect, the light control function-equipped glass has a structure in which a light control functional material is sandwiched between two glass plates. The two glass plates protect the light control functional material from the outside. In one aspect, at least one of the two glass plates is coated with a light control functional material to form a thin film. In another aspect, a solid or gel-like light control functional material is placed between the two glass plates. An example of the light control functional material may include an electrochromic material. The electrochromic material is a polymer material that gives coloring or disappears by an electrically induced reversible oxidation-reduction reaction. When a voltage is applied to the electrochromic material, its color can be changed. The light control functional material may be a material other than the electrochromic material. Examples of other light control functional materials may include an SPD, a liquid crystal, and a polymer-dispersed liquid crystal.

An additional sub plate (hereinafter, referred to as "the other sub plate") may be provided between the transparent display 22 and the light control sheet 23. At this time, the light control sheet 23 is provided between the sub plate 21b and the other sub plate. At this time, the transparent display 22 is provided between the main plate 21a and the other sub plate. Herein, the other sub plate is an optical element. The other sub plate has a predetermined transmittance and allows visible light to transmit. Herein, the optical elements included in the clear glass 20 are not limited to the optical elements described above.

In Fig. 1, similarly to the main plate 21a, the sub plate 21b may be tempered glass, laminated glass, or glass of which a base material is laminated with a material other than glass. Either of the main plate 21a or the sub plate 21b may be replaced with a plate made of a material other than glass. The material other than glass may be resin. The resin may be polycarbonate.

The transmittance of the clear glass 20 shown in Fig. 1 may be measured based on ISO 9050: 2003 or JIS R 3106: 1998. When the light control sheet 23 is bright, the clear glass 20 preferably has a transmittance of 8 to 80%. When the light control sheet 23 is dark, the clear glass 20 preferably has a transmittance of 0.5 to 60%. The clear glass 20 may have a difference in transmittance of 20 points or more between the brightness and the darkness. Here, 1 point indicates that the difference in transmittance is 1%.

An upper limit and a lower limit of a transmittance Tg(%) of the clear glass can be obtained by simply multiplying the transmittances of the respective optical elements. In one example, the transmittance of the light control sheet 23 varies from 30% to 70%. In one example, the transmittance of the set of the main plate 21a and the sub plate 21b is 90%. The transmittance of the transparent display 22 is defined as Td(%). In one example, other sub plates or other optical elements are not added to the clear glass 20. At this time, a range from darkness to brightness of the transmittance Tg(%) of the clear glass is expressed by an equation of 0.27 Td < Tg < 0.63 Td. In Fig. 1, when the transmittance Td (%) of the transparent display 22 is changed, the transmittance of the clear glass 20 can be set as indicated by Table 1 below. These are examples and do not urge a limited interpretation of the present invention.

**[Table 1]**

| Transparent Display Td(%) | Clear Glass Tg(%) | |
|---|---|---|
| | Darkness | Brightness |
| 30 | 8.1 | 18.9 |
| 40 | 10.8 | 25.2 |
| 50 | 13.5 | 31.5 |
| 60 | 16.2 | 37.8 |
| 70 | 18.9 | 44.1 |
| 80 | 21.6 | 50.4 |

The clear glass 20 shown in Fig. 1 may be used for a moving object. The moving object may be a manned transportation. The clear glass 20 may be used for a window of the transportation. The transportation includes at least a rail vehicle, an aircraft, a ship, an automobile, an elevator, a people mover, and a ropeway. The clear glass 20 may be used for a window not being a moving object. Examples of non-moving objects include buildings and cockpits of stationary construction machines and work machines. The clear glass 20 may be used for a wall window or a skylight. The clear glass 20 may be used not as a window but as glass for a floor or a transparent partition. The clear glass can be effectively used even in an underground space where there is no window between the outside and the room. The clear glass 20 may be used for signage. The signage may be installed indoors or outdoors. The clear glass 20 may be used for an operation panel.

### <Example 1>

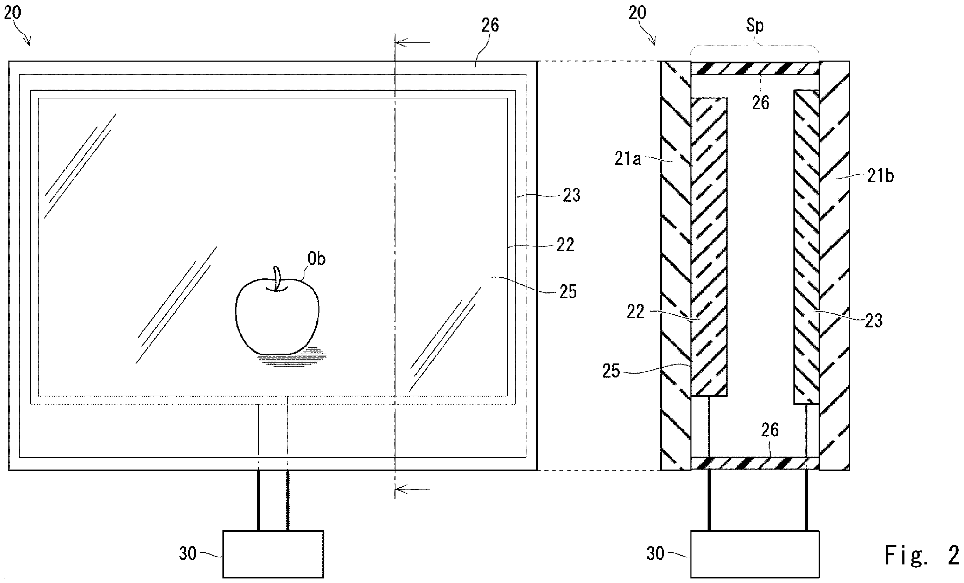

A front view of the clear glass 20 is shown on a left side of Fig. 2. In the front view, an alternate long and short dash line and an arrow indicate a cutting position. A cross-sectional view of the clear glass 20 at such a cutting position is shown on a right side of Fig. 2.

As shown in Fig. 2, the clear glass 20 is multi-layered glass. Such multi-layered glass includes display layer glass and light control layer glass. The clear glass 20 includes the main plate 21a as the display layer glass. The clear glass 20 includes the sub plate 21b as the light control layer glass. The main plate 21a and the sub plate 21b face each other.

As shown in the cross-sectional view of Fig. 2, the transparent display 22 bonds to the main plate 21a. A screen 25 of the transparent display 22 bonds to the back surface of the main plate 21a. A light control sheet 23 bonds to the sub plate 21b. The light control sheet 23 bond to the front side of the sub plate 21b. The entire surface of the transparent display 22 including the screen 25 may bond to the main plate 21a with a transparent bonding material. A part of the transparent display 22 may bond to the main plate 21a with a transparent bonding material, and another part thereof may not bond to the main plate 21a. The entire surface of the light control sheet 23 may bond to the sub plate 21b with a transparent bonding material. A part of the light control sheet 23 may bond to the sub plate 21b with a transparent bonding material, and another part thereof may not bond to the sub plate 21b. The light control sheet 23 may bond to another optical element in the clear glass 20. However, this is performed under condition that the light control sheet 23 is located behind the transparent display 22. For example, another sub plate may further bond to the front side of the light control sheet 23, for example. The adhering may be performed by adhesion.

As shown in Fig. 2, a space Sp is provided between the main plate 21a and the sub plate 21b. The transparent display 22 is provided on a side of the main plate 21a facing the space Sp. The light control sheet 23 is provided on a side of the sub plate 21b facing the space Sp. The transparent display 22 and the light control sheet 23 are installed in the space Sp.

As shown in Fig. 2, the clear glass 20 further includes a seal 26. The seal 26 blocks the space Sp in the clear glass 20 from the outside. The clear glass 20 is multi-layered glass having the space Sp enclosed therein. The seal 26 may be transparent or opaque. In one aspect, the seal 26 seals around outer circumferences of the main plate 21a and the sub plate 21b. The clear glass 20 may not include the seal 26. The clear glass 20 may have a simple structure in which the display layer glass and the light control layer glass face each other.

Examples of materials of the seal 26 shown in Fig. 2 may include a butyl-based sealing material, a silicone-based sealing material, a polysulfide-based sealing material, and a polyurethane-based sealing material. Such materials have high sealing properties, especially low water vapor permeability. By using such a sealing material, it is possible to enhance airtightness of the clear glass 20.
For example, even in a case of installation in a contaminated area such as a construction site, a clear picture can be displayed.

In Fig. 2, a controller 30 is electrically connected to the clear glass 20. Herein, the "electrically connected" means an artificial connection for transmission of a voltage change or an electric signal. Therefore, the "electrically connected" does not mean only a short circuit. Further, non-artificial connections due to parasitic capacitance or the like are not included therein.

In Fig. 2, the controller 30 is provided outside the clear glass 20. The controller 30 is electrically connected to a driver circuit included in the transparent display 22. The controller 30 is further electrically connected to the light control sheet 23. By the controller 30, driving power is supplied to the transparent display 22 and the light control sheet 23. The controller 30 has a power capacity required to drive the clear glass 20. A transparent display apparatus can be provided by a combination of the clear glass 20 and the controller 30.

In Fig. 2, by the controller 30, a picture signal is input to the transparent display 22, and the voltage applied to the light control sheet 23 is further changed. Thus, the brightness and darkness of the light control sheet 23 can be controlled according to the change in the picture displayed on the transparent display 22. Under the control of the controller 30, the clear glass 20 can switch the brightness and darkness behind the transparent display 22 according to the nature of the picture displayed on the screen 25. A picture signal may be received from the outside by the controller 30. By the controller 30, a control signal of brightness and darkness may be received from the outside and control the brightness and darkness of the light control sheet 23 according to the control signal.

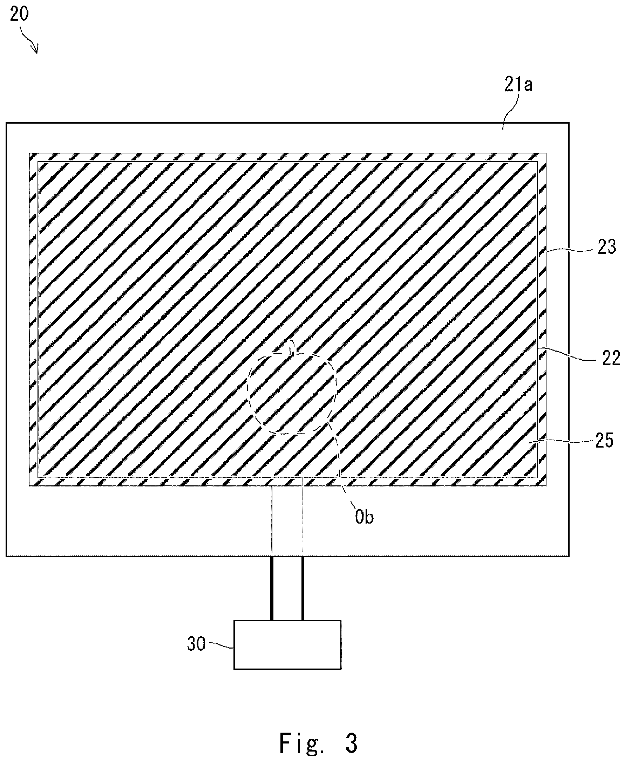

Fig. 3 shows a front view of the clear glass 20. The seal 26 disposed on the outer periphery of the main plate 21a is not described. A part of the clear glass 20 is not transparent under the control of the controller 30. This is because the light control sheet 23 is dark. Nothing is displayed on the transparent display 22. In Fig. 2, the light control sheet 23 blocks an appearance of an object Ob, which is visible through the clear glass 20. In Fig. 3, the object Ob is completely invisible.

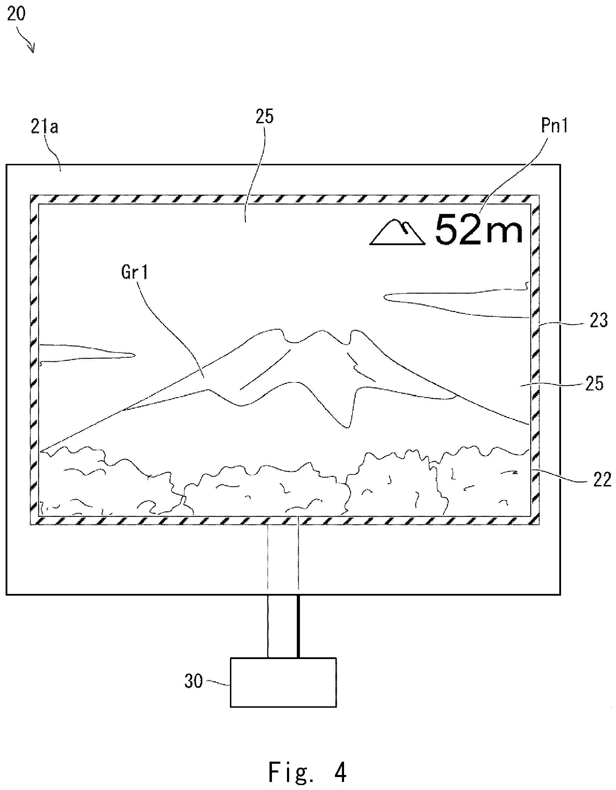

Fig. 4 shows a front view of the clear glass 20. A picture signal is input to the transparent display 22 by the controller 30. Therefore, a picture of a mountain is displayed on the screen 25. In Fig. 2, the appearance of the object Ob, which is visible through the clear glass 20, is prevented from being superimposed on the picture. In addition, halation (whiteout) of the picture due to external light is prevented.

In Fig. 4, there is no limitation on the type of picture displayed on the screen 25. The picture may include a gradation expression pattern Gr1. Mountains, trees in front of the mountains, and clouds in the sky in the picture shown in the drawing may be expressed by the gradation expression such as the pattern Gr1. The gradation expression such as the pattern Gr1 may include a real picture such as a landscape. Such a gradation expression patten may be an image with a large contrast or an image with a high resolution.

In Fig. 4, the picture includes a plain figure pattern expression such as a mountain symbol or a character "52 m" represented at an upper right of the picture. A pattern Pn1 on the screen 25 is a figure pattern having a plain texture. In the plain figure pattern, each pixel element in the figure is filled with the same color in both darkness and color. The plain figure pattern is a so-called non-gradation pattern.

For example, geometric figures, symbols, and letters are represented by the plain figure pattern. For example, computer graphics, animation, information display centered on character strings such as station name markers, geometric patterns such as color bars, and logotypes are represented by a set of plain figure patterns. Herein, for convenience, examples represented by a set of plain figure patterns are treated as a kind of plain figure pattern. The set may include figures having different colors. However, when a color density gradient is represented by a set of plain figure patterns, it is treated as gradation expression. Even when the inside of the figure pattern is represented by gradation expression, it is treated as gradation expression.

In Fig. 4, the pattern Pn1 is not limited to a completely plain pattern. The pattern Pn1 includes a border and a figure of a three-dimensional expression. The background of the pattern Pn1 may be filled with a color different in density from that of the pattern Pn1. The background of the pattern Pn1 may be dark.

In Fig. 4, the picture signal of the controller 30 includes signals for the gradation expression and the plain figure pattern expression. The controller 30 receives such a picture signal from the outside.

In Fig. 4, as the controller 30 allows the transparent display 22 to display a picture to brighten the transparent display 22, the back of the transparent display is darkened with the light control sheet 23. Further, the fact that the self-lighting-emitting transparent display 22 is transparent means that a dark picture is displayed on the transparent display 22 (Fig. 2). For example, when the input of the picture signal to the transparent display 22 is started, the light control sheet 23 may be made dark.

Fig. 4 shows control under which the back of the transparent display is darkened with the light control sheet 23 as the picture of the transparent display 22 becomes brighter. A user can arbitrarily set the timing of darkening the light control sheet 23 and brightening the transparent display 22 using the controller 30. For example, these may be performed at the same time.

A reverse process of returning in this order of Fig. 4, Fig. 3, and Fig. 2 can be performed. At this time, the controller 30 brightens the back of the transparent display with the light control sheet 23 as the picture of the transparent display 22 becomes darker. For example, when the input of the picture signal to the transparent display 22 is completed, the light control sheet 23 may be made bright. As a result, as shown in Fig. 2, the object Ob can be seen through the clear glass 20.

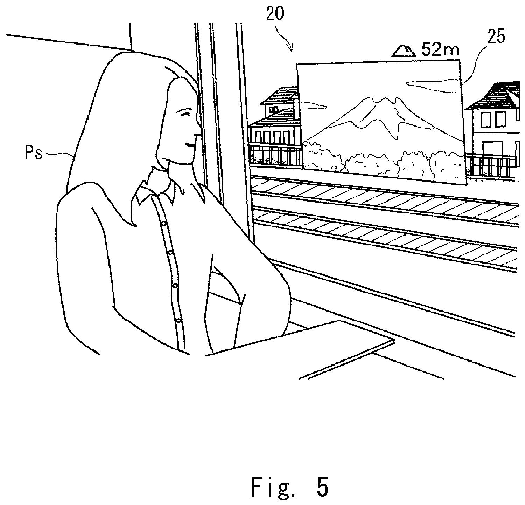

Fig. 5 is a usage diagram of the clear glass 20. The clear glass 20 is used for a window of a railway vehicle in operation. The screen 25 of the transparent display displays a picture toward the inside of the railway vehicle. The screen 25 occupies only a part of the clear glass 20. Therefore, a passenger Ps can see the picture while enjoying a scenery seen from a vehicle window. The picture can present information useful to the passenger Ps. For example, a landscape of the destination of the railway vehicle can be projected on the clear glass 20. Further, the altitude of the current location of the railway vehicle can be displayed. When the display of the picture is stopped, the clear glass 20 returns to an original transparent vehicle window. Herein, the passenger Ps can be replaced by a crew member. The passenger Ps is an example of a person who is in a transportation and is carried by the transportation.

### <Example 2>

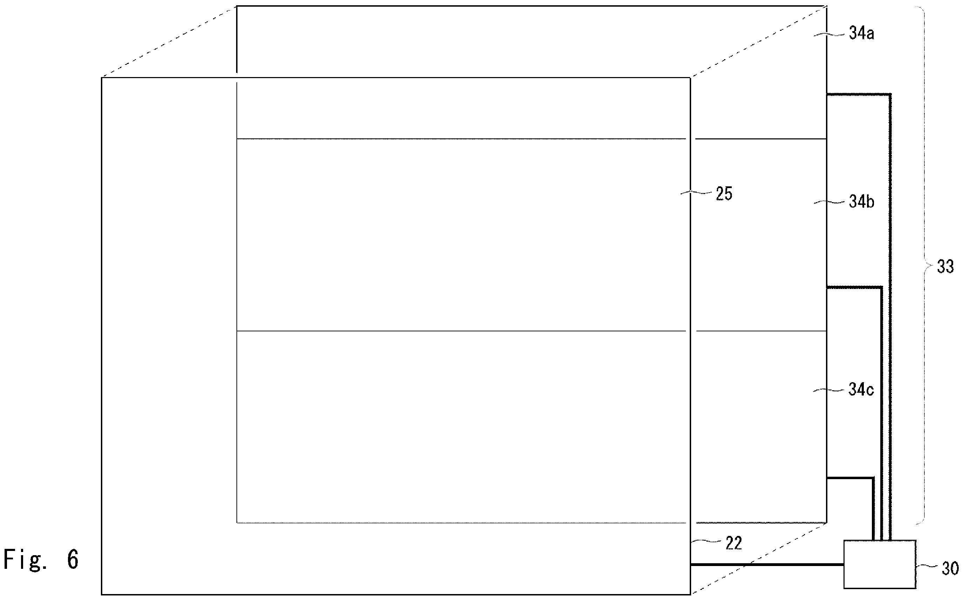

Fig. 6 shows a transparent display 22 and a light control sheet 33. In the drawing, a main plate and a sub plate are not shown. The light control sheet 33 differs from the light control sheet described above in terms of be divided for each region. The light control sheet 33 includes regions 34a, 34b, and 34c. these regions occupy an upper part, a central part, and a lower part of the light control sheet 33, respectively. The light control sheet not being divided as described above can also be used suitable for the clear glass. On the other hand, the light control sheet 33 can further control the brightness and darkness thereof for each region. Accordingly, the brightness of the back of the screen 25 can be controlled for each of the upper part, the central part, and the lower part. A dividing direction may be a vertical direction or a horizontal direction. The dividing may be performed in a tile shape by a combination of vertical and horizontal directions.

In Fig. 6, a portion of the light control sheet 33 facing the transparent display 22 is divided for each regions. In the drawing, the entire light control sheet 33 is a portion facing the transparent display 22. Therefore, the entire light control sheet 33 is divided.

As shown in Fig. 6, the controller 30 is electrically connected to each region of the light control sheet 33. The controller 30 is electrically connected to each of the regions 34a, 34b, and 34c. The controller 30 controls brightness and darkness of each of the regions 34a, 34b, and 34c.

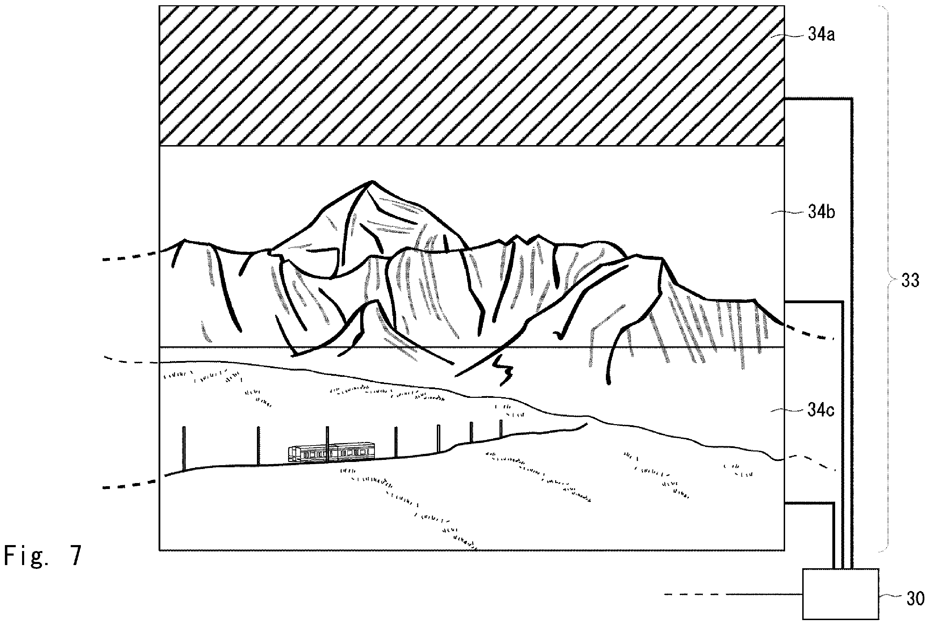

Fig. 7 shows a state of using the light control sheet 33. The controller 30 darkens the region 34a. Therefore, a scenery behind the region 34a is invisible or almost invisible through the region 34a. On the other hand, the controller 30 brightens the regions 34b and 34c. Therefore, sceneries behind the regions 34b and 34c can be seen through the region 34b or 34c. In the drawing, mountains and mountain railways can be seen.

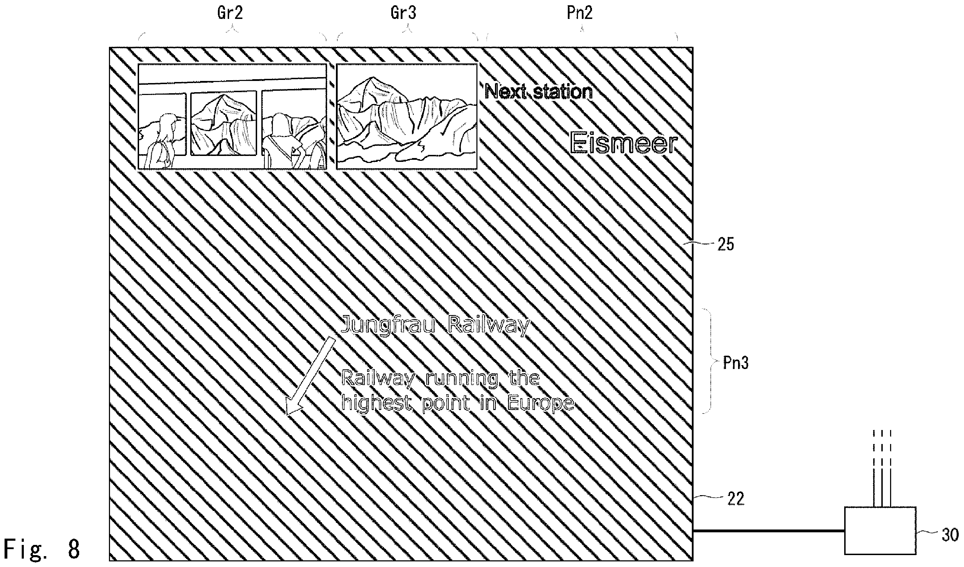

Fig. 8 shows a state of using the transparent display 22. The controller 30 is electrically connected to the transparent display 22. A picture signal is input to the transparent display 22 by the controller 30. The picture signal includes gradation expressions (patterns Gr2 and Gr3) and plain figure pattern expressions (patterns Pn2 and Pn3) which are displayed simultaneously with each other.

As shown in Fig. 8, a picture including the patterns Gr2 and Gr3 and the pattern Pn2 are displayed on an upper part of the screen 25. A picture including the pattern Pn3 is displayed from a central part to a lower part of the screen 25. These pictures are collectively displayed on the screen 25. In addition, the background in the picture is dark. In other words, light emitted from the back of the self-lighting-emitting transparent display 22 transmits through the transparent display 22.

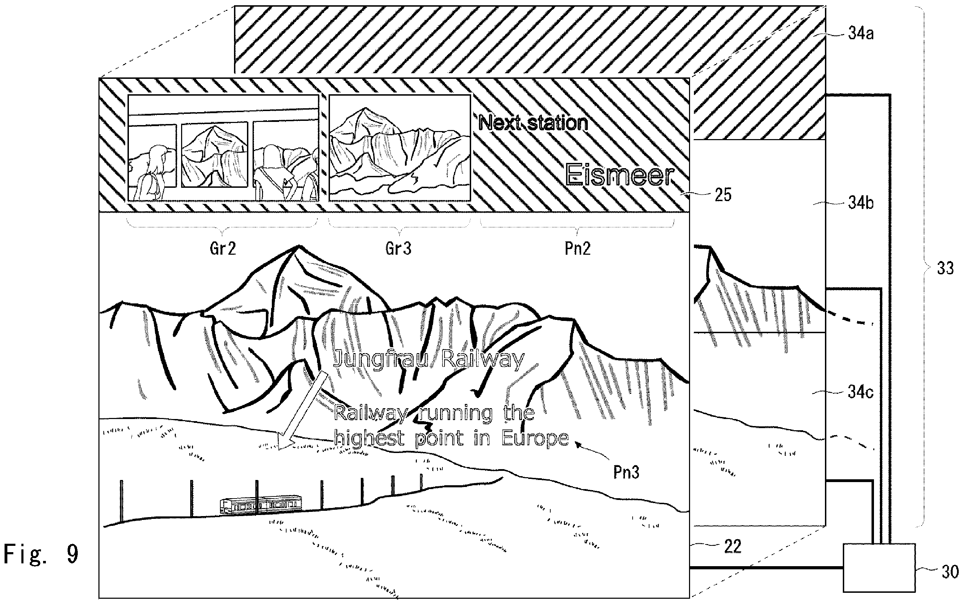

Fig. 9 shows a state in which the light control sheet 33 and the transparent display 22 are used at the same time. The region 34a darkly covers the upper part of the screen 25. Therefore, the patterns Gr2 and Gr3 and the pattern Pn2 uniformly emerge in the dark background. On the other hand, the regions 34b and 34c brighten the bac of the transparent display 22 from the central part to the lower part of the screen 25. Therefore, the pattern Pn3 is superimposed on the bright scenery.

The inventors have found that when the gradation expression pattern displayed on the self-lighting-emitting transparent display is superimposed on the actual scenery, such a pattern is less visible than when the plain figure pattern is superimposed on the actual scenery. This indicates that the gradation expression pattern is vulnerable to halation due to external light.

In this example, as shown in Fig. 9, the gradation expression picture, that is, the region 34a behind the patterns Gr2 and Gr3 is darker than the plain figure pattern expression picture, that is, the regions 34b and 34c behind the pattern Pn3. In addition, the plain figure pattern expression picture, that is, the pattern Pn2 is also superimposed on the region 34a in the drawing.

As shown in Fig. 9, the light control sheet 33 can darken the back of the transparent display 22 only in the region where the gradation expression pattern is used. Therefore, the scenery can be seen in the region where the gradation expression pattern is not used. Further, in the region where the gradation expression pattern is used, the gradation expression pattern can be easily seen regardless of the brightness of the scenery.

As shown in Fig. 9, the pattern Pn3 being the plain figure pattern can be displayed to be aligned with an object in the scenery. In the drawing, the pattern Pn3 is displayed to be aligned with the railway track on which the railway vehicle runs in the scenery.

### <Example 3>

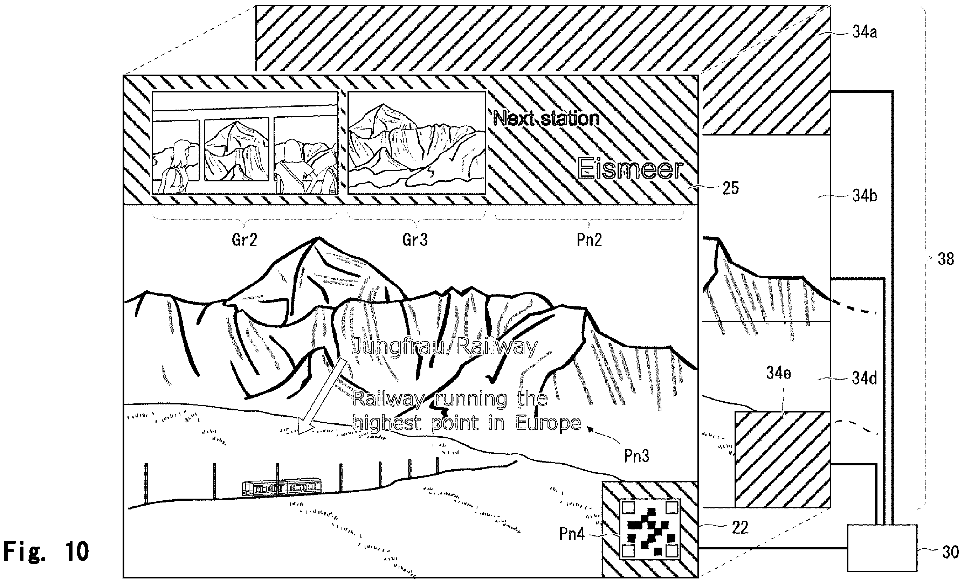

Fig. 10 shows a transparent display 22 and a light control sheet 38. The light control sheet 38 is similar to the light control sheet 33 shown in Fig. 9 except for the following points. The light control sheet 38 includes regions 34d and region 34e instead of the region 34c shown in Fig. 9. The region 34e is a part obtained by division of the region 34c shown in Fig. 9. The region 34d is the rest part.

As shown in Fig. 10, a picture further includes a pattern Pn4 which is a plain figure pattern. The pattern Pn4 is a picture of a two-dimensional code. The region 34e is a region behind the pattern Pn4 of the transparent display 22. The region 34d is brightened to transmit the image of the scenery. The region 34e is a region behind the pattern Pn4 which is the plain figure pattern. Therefore, the region 34e is also a region that may be originally brightened. However, the region 34e is exceptionally darkened in this example. Thereby, the two-dimensional code in the pattern Pn4 can be displayed more clearly. Accordingly, the two-dimensional code displayed in the picture can be easily scanned with a mobile information terminal such as a smartphone.

### <Example 4>

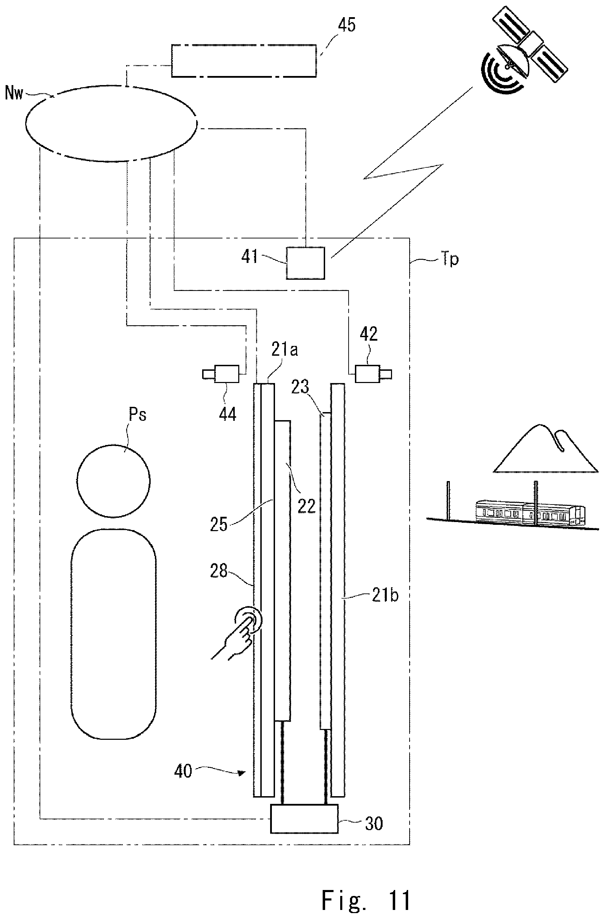

Fig. 11 shows a usage diagram of the clear glass 40 arranged in the transportation Tp. The figure includes the clear glass 40 viewed from the left side. The clear glass 40 is the same as the clear glass 20 shown in Figs. 1 to 5 except for the following points. In the drawing, the seal connecting the main plate 21a and the sub plate 21b is omitted.

As shown in Fig. 11, the clear glass 40 includes a touch panel 28 further provided on the front side of the main plate 21a. The touch panel 28 is provided on the side opposite to the transparent display 22 with the main plate 21a interposed therebetween. The touch panel 28 faces the screen 25. The passenger Ps can touch the touch panel 28 with his/her fingers. The touch panel 28 may be of a capacitance type, an infrared scanning type, or a resistive film type. The detection method of the touch panel 28 is not limited at all.

In Fig. 11, the clear glass 40 is used as a partition inside the transportation Tp or a window for partitioning the inside and outside of the transportation Tp. Here, how to use it as a window is described. The front of the clear glass 40 is directed toward the position of the passenger Ps in the transportation Tp. The front of the clear glass 40 is the front side of the screen 25.

In Fig. 11, the passenger Ps inputs a request of the passenger Ps via the touch panel 28. An example of the request is the ordering of drinks and souvenirs offered in the transportation Tp. The clear glass 40 transmits basic information from the transportation Tp to a server 45 through a network Nw. Here, the basic information is the input request.

In Fig. 11, the server 45 receives the basic information. The server 45 analyzes the basic information. The server 45 further generates service information to be provided to the passenger Ps based on the analysis result. An example of service information is a two-dimensional code for settlement of ordered products. The server 45 transmits service information through the network Nw.

In Fig. 11, the transportation Tp receives the service information. The transportation Tp displays the received service information as a picture on the transparent display 22. If the service information is a two-dimensional code, the transparent display 22 may display the two-dimensional code as shown in FIG. 10. At this time, the brightness behind the picture displayed on the screen 25 may be determined based on the service information. The brightness behind the picture is controlled by the light control sheet 23. If the service information is a two-dimensional code, the light control sheet 38 shown in Fig. 10 may be used instead of the light control sheet 23.

The basic information transmitted to the server 45 in Fig. 11 is not limited to the request input via the touch panel 28. In one aspect, the current position of the transportation Tp may be basic information. In this aspect, the clear glass 40 having no touch panel 28 attached may also be used. The transportation Tp includes a GPS (Global Positioning System) signal receiver 41. The transportation Tp receives the signal at the receiver 41. The receiver 41 or other device executes an operation on the signal. The transportation Tp acquires the current position of the transport Tp as a result of the operation.

In one aspect, the transportation Tp may include a camera 42 as shown in Fig 11. The camera 42 photographs the outside of the transportation Tp to obtain an image. The transportation Tp analyzes the image to acquire the current position of the transportation Tp.

In Fig. 11, the transportation Tp transmits the current position of the transportation Tp to the server 45 through the network Nw as basic information. The server 45 receives the basic information. The server 45 generates information about the scenery seen from the transportation Tp as service information based on the current position of the transportation Tp. The server 45 transmits the service information to the transportation Tp. The transportation Tp receives the service information. The transportation Tp displays the service information on the clear glass 40. For example, as shown in Fig. 9, the transparent display 22 may display the next station as the pattern Pn2.

In one aspect shown in Fig. 11, the basic information may be information in the transportation Tp. In this aspect, the clear glass 40 having no touch panel 28 attached may also be used. The basic information is information related to passenger Ps. The basic information is obtained based on the photography inside the transportation Tp. The transportation Tp includes a camera 44. The camera 44 photographs the inside of the transportation Tp to obtain an image. The transportation Tp analyzes the image to acquire information related to the passenger Ps. An example of information related to the passenger Ps is the location information of passenger Ps. Here, the information that the passenger Ps exists in front of the clear glass 40 is taken as an example.

In Fig. 11, the transportation Tp transmits the existence of the passenger Ps to the server 45 through the network Nw as basic information. The server 45 receives the basic information. The server 45 generates information about the scenery seen from the transportation Tp as service information based on the existence of passengers Ps. The server 45 transmits the service information to the transportation Tp. The transportation Tp receives the service information. The transportation Tp displays the service information on the clear glass 40. For example, as shown in Fig. 9, the transparent display 22 may display the introduction of the railway as the pattern Pn3.

### <Example 5>

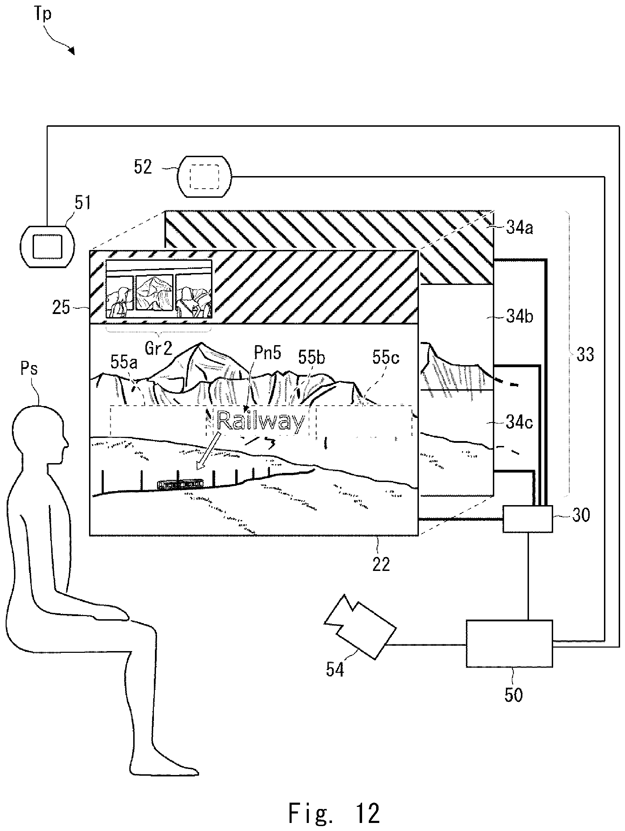

Fig. 12 shows a usage diagram of the transparent display 22 and the light control sheet 33 in the transportation Tp. The transportation Tp includes a computer 50. The computer 50 may be a microcomputer or a general-purpose computer. The computer 50 sends a picture signal to the transparent display 22 via the controller 30. The computer 50 sends a signal to control the brightness of the light control sheet 33, to the controller 30.

In Fig. 12, the transportation Tp includes an interior sensor 51. The interior sensor 51 is an illuminance sensor located on the front side of the transparent display 22. The front of the transparent display 22 is the inside of the transportation Tp. The transportation Tp further includes an exterior sensor 52. The exterior sensor 52 is an illuminance sensor located further behind the light control sheet 33. Further behind the light control sheet 33 is the outside of the transportation Tp.

As shown in Fig. 12, in one aspect, the controller 30 is electrically connected to the interior sensor 51 via the computer 50. The interior sensor 51 measures the illuminance in front of the transparent display 22. The interior sensor 51 sends the measured illuminance values to the computer 50. The computer 50 receives illuminance values continuously or periodically. The computer 50 determines the brightness of the picture displayed on the transparent display 22 according to the illuminance value. The computer 50 adjusts the brightness of the picture signal. The computer 50 determines the brightness of the light control sheet 33 according to the illuminance value. The brightness of the light control sheet 33 is determined for each of the regions 34a, 34b and 34c. The computer 50 generates a control signal for controlling the brightness of the light control sheet 33. The computer 50 sends a picture signal and a control signal to the controller 30. The controller 30 receives a picture signal and a control signal. The controller 30 further sends a picture signal to the transparent display 22. The controller 30 determines the voltage applied to each of the regions 34a, 34b, and 34c based on the control signal. The controller 30 applies a voltage to each of the regions 34a, 34b, and 34c, or lowers the applied voltage.

As shown in Fig. 12, in one aspect, the controller 30 is electrically connected to the exterior sensor 52 via the computer 50. The exterior sensor 52 measures the illuminance further behind the light control sheet 33. The exterior sensor 52 sends the measured illuminance values to the computer 50. The computer 50 receives illuminance values continuously or periodically. The computer 50 determines the brightness of the picture displayed on the transparent display 22 according to the illuminance value. The computer 50 adjusts the brightness of the picture signal. The computer 50 determines the brightness of the light control sheet 33 according to the illuminance value. The brightness of the light control sheet 33 is determined for each of the regions 34a, 34b and 34c. The computer 50 generates a control signal for controlling the brightness of the light control sheet 33. The computer 50 sends a picture signal and a control signal to the controller 30. The controller 30 receives a picture signal and a control signal. The controller 30 further sends a picture signal to the transparent display 22. The controller 30 determines the voltage applied to each of the regions 34a, 34b, and 34c based on the control signal. The controller 30 applies a voltage to each of the regions 34a, 34b, and 34c, or lowers the applied voltage.

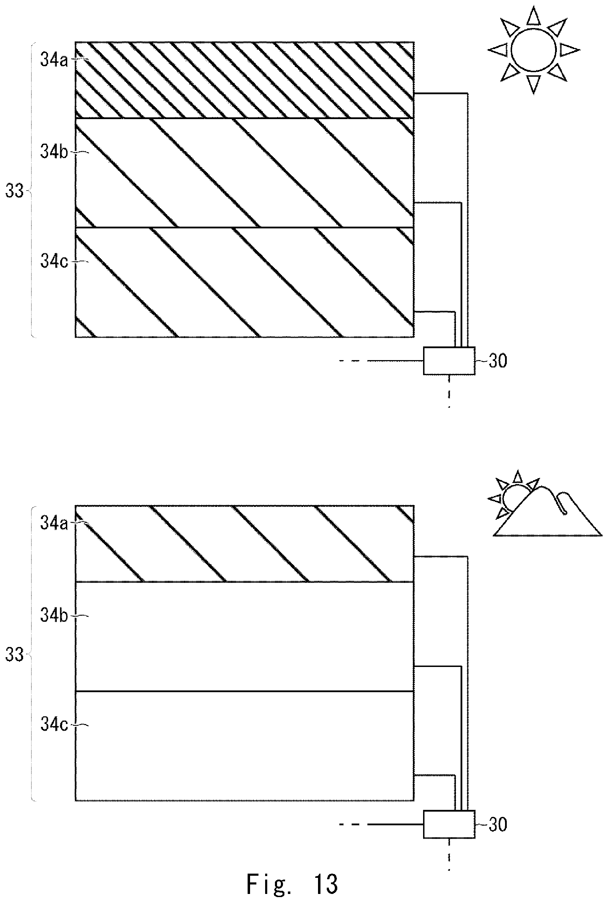

Fig. 13 shows a usage diagram of the light control sheet 33. In the upper part, the illuminance behind the light control sheet 33 is increasing. The controller 30 darkens the light control sheet 33. The darkness of the light control sheet 33 is different between the region 34a and the set of regions 34b and 34c. The region 34a is fully darkened. The set of regions 34b and 34c has brightness set to an intermediate state. As shown in Fig. 9, the region 34a is suitable for displaying the gradation expression patterns Gr2 and Gr3. As shown in Fig. 9, the set of regions 34b and 34c is suitable for displaying the pattern Pn3 of the plain figure pattern expression. The set of regions 34b and 34c also serves as a shade. The set of regions 34b and 34c reduces the sunlight shining from behind the light control sheet 33 toward the front.

In the lower part of Fig. 13, the illuminance behind the light control sheet 33 is reducing. The controller 30 brightens the light control sheet 33. The darkness of the light control sheet 33 is different between the region 34a and the set of regions 34b and 34c. The region 34a has brightness set to an intermediate state. The set of regions 34b and 34c is fully brightened. As shown in Fig. 9, the region 34a is suitable for displaying the gradation expression patterns Gr2 and Gr3. As shown in Fig. 9, the set of regions 34b and 34c is suitable for displaying the pattern Pn3 of the plain figure pattern expression. The set of regions 34b and 34c serves for lighting.

### <Example 6>

Description is to be made by returning to Fig. 12. The transportation Tp includes a camera 54. The front of the transparent display 22 is directed in advance toward the position of the passenger Ps in the transportation Tp. That is, the front of the transparent display 22 faces the passenger room. The camera 54 is a surveillance camera. The camera 54 monitors the direction of the line of sight of the passenger Ps. The camera 54 continuously or periodically acquires the direction of the line of sight. The camera 54 sends the direction of the line of sight to the computer 50. The computer 50 continuously or periodically acquires the direction of the line of sight.

In Fig. 12, a determination is made as to the position for displaying the information, to be displayed on the transparent display 22, in the transparent display 22. As an example of the information, a plain figure expression pattern Pn5 is shown in the figure. As the position for displaying, the positions 55a, 55b and 55c are shown in order from the left when the transparent display 22 is viewed from the front. The transparent display 22 displays the pattern Pn5 at any of the positions 55a, 55b and 55c. In the figure, the transparent display 22 is displayed at the position 55b at the center of the pattern Pn5.

In Fig. 12, the computer 50 determines the position for displaying the pattern Pn5, based on the direction of the line of sight of the passenger Ps. In the figure, the computer 50 centers the position for displaying the pattern Pn5. The computer 50 generates a picture signal, based on the position for displaying. The computer 50 sends a picture signal to the controller 30. The controller 30 receives a picture signal. The controller 30 further sends a picture signal to the transparent display 22. The transparent display 22 displays a picture. In the picture, the pattern Pn5 is located at position 55b.

### <Example 7>

The pattern Pn3, which is a plain figure pattern expression displayed on the clear glass in Fig. 9, can be further replaced with a low gradation expression. The low gradation expression is "an expression close to a single color". The "single color" is a color that is emitted from the light emitting pixel elements of a transparent display, for example, red, blue, green, or a combination thereof, in a state in which no electrical adjustment is performed. The "expression close to a single color" is, in the definition of single color, an expression using an emission color when each light emitting element is slightly electrically adjusted.

In Fig. 9, the pattern Pn3 can be further replaced with a warm color expression. The "warm color expression" is an expression using colors that impress the viewer with a warm feeling, such as red and yellow.

In Fig. 9, the pattern Pn3 may be a low gradation expression and warm color expression. The "low gradation expression and warm color expression" is an expression using a color that impresses the viewer with a warm feeling, such as red or yellow, and that includes electrical adjustment.

The patterns Gr2 and Gr3, which are gradation expressions displayed on the clear glass in Fig. 9, can be further replaced with high dynamic range expressions. A high dynamic range expression is an "expression including a multi-stage color". A "multi-stage color" is a color that contains much density in color and brightness. In addition, an "expression including multi-stage colors" is an expression that cannot be expressed in a single color, such as scenery photographs and portrait photographs.

In Fig. 9, the patterns Gr2 and Gr3 can be further replaced with a dark/cold color expression. A "dark/cold color expression" is an expression that gives a visually cold impression, including a lot of blue-based color.

In Fig. 9, the patterns Gr2 and Gr3 may be a high dynamic range expression and dark/cold color expression. A "high dynamic range expression and dark/cold color expression" is a blue-based color that gives a visually cold impression, including much density in color and brightness.

In Fig. 9, for example, the patterns Gr2 and Gr3 may be a high dynamic range expression, and the pattern Pn3 may be a low gradation expression. At this time, the region 34a behind the patterns Gr2 and Gr3 is made darker than the set of the regions 34b and 34c behind the pattern Pn3. This can give the effect of improving the contrast of the expression including the density in color and brightness.

In Fig. 9, for example, the patterns Gr2 and Gr3 may be a dark/cold color expression, and the pattern Pn3 may be a warm color expression. At this time, the region 34a behind the patterns Gr2 and Gr3 is made darker than the set of the regions 34b and 34c behind the pattern Pn3. This can give the effect of improving the contrast of the expression including the density in color and brightness.

High dynamic range expression and warm color expression are contrasted. The contrast between the high dynamic range expression and the warm color expression can be indexed by the quantity of density in color, the quantity of density in brightness, and/or the quantity of black expression. In Fig. 9, for example, the patterns Gr2 and Gr3 may be a high dynamic range expression, and the pattern Pn3 may be a warm color expression. At this time, the region 34a behind the patterns Gr2 and Gr3 is made darker than the set of the regions 34b and 34c behind the pattern Pn3. This can give the effect of improving the contrast of the expression including the density in color and brightness.

Dark/cold color expressions and low gradation expressions are contrasted. The contrast between the dark/cold color expression and the low gradation expression can be indexed by the quantity of density in color, the quantity of density in brightness, or the quantity of black expression. In Fig. 9, for example, the patterns Gr2 and Gr3 may be a dark/cold color expression, and the pattern Pn3 may be a low gradation expression. At this time, the region 34a behind the patterns Gr2 and Gr3 is made darker than the set of the regions 34b and 34c behind the pattern Pn3. This can give the effect of improving the contrast of the expression including the density in color and brightness.

### <Example 8>

For example, BSCR (Brightness Sense's Contrast Ratio) described in Non-Patent Document 1 may be used as an index for evaluation and calibration of a picture of clear glass. For example, for a measurement environment, an environment with outdoor luminance can be reproduced for measurement by preparing a white screen, illuminating the white screen with an LED light source, and using the indirect light. Visibility in a bright environment includes a perceptual component depending on whether brightness is prioritized or color is prioritized. Therefore, in order to eliminate this perceptual part as much as possible, the visibility index uses the point at which a specific character or pattern can be seen while the luminance increases.

This application claims priority on the basis of Japanese Patent Application No. 2018-231268 filed on December 11, 2018, and incorporates all of its disclosures herein.

### Reference Signs List

20 CLEAR GLASS, 21a MAIN PLATE, 21b SUB PLATE, 22 TRANSPARENT DISPLAY, 23 LIGHT CONTROL SHEET, 25 SCREEN, 26 SEAL, 28 TOUCH PANEL, 30 CONTROLLER, 33 LIGHT CONTROL SHEET, 34a-e REGION, 38 LIGHT CONTROL SHEET, 40 CLEAR GLASS, 41 RECEIVER, 42 CAMERA, 44 CAMERA, 45 SERVER, 50 COMPUTER, 51 INTERIOR SENSOR, 52 EXTERIOR SENSOR, 54 CAMERA, 55a-c POSITION, Gr1-3 GRADATION EXPRESSION PATTERN, Nw NETWORK, Ob OBJECT, Pn1-5 SOLID FIGURE PATTERN, Ps PASSENGER, Sp SPACE, Tp TRANSPORTATION

## Claims

1. Clear glass including a transparent display in which picture elements emit light by themselves, the clear class further comprising
a light control sheet covering a back of the transparent display, wherein
while a picture is displayed on the transparent display, light and darkness of the light control sheet is capable of being controlled in accordance with a magnitude of voltage applied to the light control sheet, and
the light and darkness of the light control sheet is controlled such that the light control sheet is made to be bright by increasing a transmittance of the light control sheet and is made to be dark by decreasing the transmittance of the light control sheet.

2. The clear glass according to Claim 1, comprising
display layer glass and light control layer glass that face each other, wherein
the transparent display is attached to the display layer glass, and
the light control sheet is attached to the light control layer glass.

3. The clear glass according to Claim 2, wherein
a space is provided between the display layer glass and the light control layer glass, and
the transparent display and the light control sheet are provided on the space side of the display layer glass and the light control layer glass, respectively.

4. The clear glass according to Claim 3, wherein
the clear glass is a multi-layered glass including the display layer glass and the light control layer glass, and
the space is enclosed.

5. The clear glass according to Claim 3, further comprising a touch panel that is provided on a surface of the display layer glass, the surface being on an opposite side of the display layer glass from the transparent display.

6. The clear glass according to Claim 1, wherein a part of the light control sheet is divided into regions, the part facing the transparent display, and light and darkness of each of the regions is capable of being controlled.

7. The clear glass according to Claim 1, wherein the light control sheet is of any one of a suspended particle device (SPD) type, a polymer dispersed liquid crystal (PDLC) type, a guest host liquid crystal (GHLC) type, and an electrochromic type.

8. The clear glass according to Claim 7, wherein
the light control sheet is made to be bright while voltage is applied to the light control sheet, whereas the light control sheet is made to be dark while no voltage is applied to the light control sheet, or
the light control sheet is made to be dark while voltage is applied to the light control sheet, whereas the light control sheet is made to be bright while no voltage is applied to the light control sheet.

9. A controller that is to be connected to the clear glass according to any one of Claims 1 to 8, wherein while inputting a picture signal to the transparent display, the picture signal being received from an outside, the controller controls light and darkness of the light control sheet by changing voltage applied to the light control sheet based on a control signal received from an outside.

10. The controller according to Claim 9, wherein
as a picture on the transparent display is made to be bright, a back of the transparent display is made to be dark with the light control sheet, and
as the picture on the transparent display is made to be dark, the back of the transparent display is made to be bright with the light control sheet.

11. A transparent display apparatus comprising:
the clear glass according to any one of Claims 1 to 8; and
a controller that is to be connected to the clear glass, the controller
wherein while inputting a picture signal to the transparent display, the controller controls light and darkness of the light control sheet by changing voltage applied to the light control sheet.

12. The transparent display apparatus according to Claim 11, further comprising an illuminance sensor configured to measure illuminance of a back of the light control sheet, wherein
the illuminance is acquired from the illuminance sensor continuously or periodically, and
the controller makes the light control sheet dark when the illuminance is increased, and the controller makes the light control sheet bright when the illuminance is decreased.

13. The transparent display apparatus according to Claim 11, wherein
a part of the light control sheet is divided into regions, the part facing the transparent display, and the controller is connected to each of the regions of the light control sheet,
the picture signal includes a gradation expression and a solid figure pattern expression that are to be displayed simultaneously with each other, and
the controller makes one of the regions of the light control sheet, the one of the regions being behind a picture of the gradation expression in the transparent display, darker than one of the regions of the light control sheet, the one of the regions being behind a picture of the solid figure pattern expression in the transparent display.

14. The transparent display apparatus according to Claim 13, wherein
the solid figure pattern expression includes a two-dimensional code, and
the controller exceptionally makes one of the regions that is behind a picture of the two-dimensional code in the transparent display dark.

15. A method for using the clear glass according to Claim 5 in a transportation, the method comprising:
(A)
transmitting a request as basic information from the transportation to a server over a network, the request being input by a passenger or a crew member with the touch panel;
(B)
analyzing the basic information received by the server, further generating service information to be provided to a passenger or a crew member based on a result of the analysis, and further transmitting the service information from the server over the network; and
(C)
displaying the service information received by the transportation on the transparent display in a form of a picture, further, determining light and darkness of a back of the picture based on the service information and controlling the light, and light and darkness of the back of the picture with the light control sheet.

16. A method for using the clear glass according to any one of Claims 1 to 4, 7, and 8 in a transportation, the method comprising:
(A)
transmitting, from the transportation to a server over a network, at least any one of pieces of basic information:
a position of the transportation that is acquired by reception of a GPS signal or capturing an image of an exterior of the transportation; and
information on an interior of the transportation that is obtained by capturing an image of the interior of the transportation, the information including or not including information on a passenger or a crew member;
(B)
analyzing the basic information received by the server, further generating service information to be provided to a passenger or a crew member based on a result of the analysis, and further transmitting the service information from the server over the network; and
(C)
displaying the service information received by the transportation on the transparent display in a form of a picture, further, determining light and darkness of a back of the picture based on the service information and controlling the light, and light and darkness of the back of the picture with the light control sheet.

17. A method for using the clear glass according to any one of Claims 1 to 4, 7, and 8 in a transportation, the method comprising:
placing the clear glass in advance such that a front face of transparent display faces a position of a passenger or a crew member in the transportation;
acquiring a direction of a line of sight of the passenger or the crew member with a monitoring camera provided in the transportation; and
determining, based on the direction of the line of sight of the passenger or the crew member, a display position of information in the transparent display, the information being to be displayed on the transparent display.
